(19) Europäisches Patentamt
European Patent Office
Office européen des brevets

(11) **EP 4 349 558 A1**

(12) **EUROPEAN PATENT APPLICATION**
published in accordance with Art. 153(4) EPC

(43) Date of publication:
**10.04.2024 Bulletin 2024/15**

(21) Application number: **22816026.3**

(22) Date of filing: **30.05.2022**

(51) International Patent Classification (IPC):
***B29B 11/16*** (2006.01)    ***B32B 5/02*** (2006.01)
***B32B 5/28*** (2006.01)    ***C08J 5/24*** (2006.01)
***H05K 1/03*** (2006.01)    ***H05K 3/46*** (2006.01)

(52) Cooperative Patent Classification (CPC):
**B29B 11/16; B32B 5/02; B32B 5/28; C08J 5/24;
H05K 1/03; H05K 3/46**

(86) International application number:
**PCT/JP2022/021851**

(87) International publication number:
**WO 2022/255278 (08.12.2022 Gazette 2022/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.06.2021 PCT/JP2021/020905**

(71) Applicant: **Resonac Corporation
Tokyo 105-7325 (JP)**

(72) Inventors:
• **TONOUCHI, Shunsuke
Tokyo 100-6606 (JP)**
• **KITAJIMA, Takayo
Tokyo 100-6606 (JP)**

• **MAGOTA, Seiya
Tokyo 100-6606 (JP)**
• **AOYAMA, Kazuki
Tokyo 100-6606 (JP)**
• **SHIMAOKA, Shinji
Tokyo 100-6606 (JP)**
• **TOSAKA, Yuji
Tokyo 100-6606 (JP)**
• **SAITOH, Takeshi
Tokyo 100-6606 (JP)**
• **SASAKI, Ryohta
Tokyo 100-6606 (JP)**
• **NAKANISHI, Kota
Tokyo 100-6606 (JP)**

(74) Representative: **Hoffmann Eitle
Patent- und Rechtsanwälte PartmbB
Arabellastraße 30
81925 München (DE)**

(54) **PREPREG, LAMINATED PLATE, METAL-CLAD LAMINATED PLATE, PRINTED WIRING BOARD, SEMICONDUCTOR PACKAGE, METHOD FOR MANUFACTURING PREPREG, AND METHOD FOR MANUFACTURING METAL-CLAD LAMINATED PLATE**

(57)     Provided is a prepreg including a fiber substrate having a thickness of 40 $\mu$m or more impregnated with a thermosetting resin composition, the prepreg having in the fiber substrate an impregnated region and a non-impregnated region with the thermosetting resin composition, having a surface waviness (Wa) of 5.0 $\mu$m or less.

Also provided are a laminate, a metal-clad laminate, a printed wiring board, and a semiconductor package, which are obtained by using the prepreg, a method of producing the prepreg, and a method of producing the metal-clad laminate.

Fig. 1

Resin film

Non-impregnated region with
thermosetting resin composition

Fiber substrate

**Description**

Technical Field

The present disclosure relates to a prepreg, a laminate, a metal-clad laminate, a printed wiring board, a semiconductor package, a method of producing a prepreg, and a method of producing a metal-clad laminate.

Background Art

Most of the prepregs for a printed wiring board have been produced by impregnating a fiber substrate with a resin varnish, followed by drying (see, for example, PTL 1).

In association with the increased density of semiconductor packages and the increased communication rate in recent years, a printed wiring board is demanded to have lower warpage, high reliability, and enhanced impedance controllability. For addressing the demands, it is necessary to reduce the thickness variation of the copper-clad laminate than ever before. However, there is a tendency that the copper-clad laminate produced with a prepreg obtained by the ordinary method including impregnating the fiber substrate with a resin varnish, followed by drying, has a varied thickness.

Apart from the impregnation of a fiber substrate with a resin varnish, the known methods include a method of producing a prepreg including producing a resin film with a thermosetting resin composition in advance, and then adhering a fiber substrate and the resin film under heating and pressurizing (see, for example, PTL 2).

Citation List

Patent Literatures

PTL 1: JP 01-272416 A

PTL 2: JP 2011-132535 A

Summary of Invention

Technical Problem

PTL 2 describes that a prepreg excellent in thickness accuracy can be produced. However, according to the further investigations by the present inventors, it has been found that a prepreg that has a fiber substrate having a small thickness, for example, 35 $\mu$m or less, results in excellent thickness accuracy, but in the case where the thickness of the fiber substrate is larger than that value, the thickness accuracy of the prepreg is deteriorated, eventually resulting in a tendency of deterioration of the thickness accuracy of the copper-clad laminate.

Under the circumstances, an object of the present disclosure is to provide a prepreg capable of achieving a metal-clad laminate having high thickness accuracy even in the case where a fiber substrate having a thickness of 40 $\mu$m or more is used; to provide a laminate, a metal-clad laminate, a printed wiring board, and a semiconductor package, which are obtained by using the prepreg; and to provide a method of producing the prepreg and a method of producing the metal-clad laminate.

Solution to Problem

As a result of the accumulated studies by the present inventors, it has been found that the object can be achieved by the present disclosure. The present disclosure includes the following items [1] to [12].

[1] A prepreg including a fiber substrate having a thickness of 40 $\mu$m or more impregnated with a thermosetting resin composition, the prepreg having in the fiber substrate an impregnated region and a non-impregnated region with the thermosetting resin composition, having a surface waviness (Wa) of 5.0 $\mu$m or less.

[2] The prepreg according to the item [1], wherein the prepreg has an existing ratio of the impregnated region obtained by the following calculation method of 25 to 98%:

calculation method: a surface of the prepreg is observed with an optical microscope at a magnification of 50 to provide a surface observation image; the resulting surface observation image is converted to monochrome mode with image editing software, and saved in BMP (Microsoft Windows Bitmap Image) format; the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.

[3] The prepreg according to the item [2], wherein the existing ratio of the impregnated region is 35 to 90%.

[4] The prepreg according to any one of the items [1] to [3], wherein the prepreg has a surface roughness (Ra) of 0.1 to 5 $\mu$m.

[5] The prepreg according to any one of the items [1] to [4], wherein the fiber substrate has a thickness of 70 to 120 $\mu$m.

[6] A laminate including one or more plies of the prepreg according to any one of the items [1] to [5].

[7] A metal-clad laminate including a metal foil and one or more plies of the prepreg according to any one of the items [1] to [5].

[8] A printed wiring board including the laminate according to the item [6] or the metal-clad laminate according to the item [7].

[9] A semiconductor package including the printed wiring board according to the item [8] and a semiconductor device.

[10] A method of producing a prepreg having a surface waviness (Wa) of 5.0 $\mu$m or less, including impregnating a fiber substrate having a thickness of 40 $\mu$m or more with a film of a thermosetting resin composition through lamination, the method of producing a prepreg including providing in the fiber substrate an impregnated region and a non-impregnated region with the thermosetting resin composition.

[11] The method of producing a prepreg according to the item [10], wherein the prepreg has an existing ratio of the impregnated region obtained by the following calculation method of 25 to 98%:

calculation method: a surface of the prepreg is observed with an optical microscope at a magnification of 50 to provide a surface observation image; the resulting surface observation image is converted to monochrome mode with image editing software, and saved in BMP (Microsoft Windows Bitmap Image) format; the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.

[12] A method of producing a metal-clad laminate, including disposing metal foils on both surfaces of one ply of a prepreg produced by the production method according to the item [10] or [11], or on both surfaces of a prepreg laminate including one or more plies of the prepreg, and then press-molding.

Advantageous Effects of Invention

The present disclosure can provide a prepreg capable of achieving a metal-clad laminate having high thickness accuracy even in the case where a fiber substrate having a thickness of 40 $\mu$m or more is used, can provide a laminate, a metal-clad laminate, a printed wiring board, and a semiconductor package, which are obtained by using the prepreg, and can provide a method of producing the prepreg and a method of producing the metal-clad laminate.

Brief Description of Drawings

Fig. 1 is a schematic cross sectional view showing one embodiment of the prepreg of the present embodiment.
Fig. 2 is a schematic cross sectional view showing a prepreg produced by the ordinary method including impregnating the fiber substrate with a resin varnish, followed by drying.
Fig. 3 is a cross sectional view of the prepreg of the present embodiment for describing the thickness of the fiber substrate and the resin thicknesses of the resins on front and back sides thereof.
Fig. 4 is a surface observation image obtained by converting the surface observation image to monochrome mode for calculating the existing ratio of the impregnated region in the prepreg produced in Example 2.

Description of Embodiments

One embodiment of the present disclosure will be described below, but the present disclosure is not limited to the embodiment described below.

In the numerical range described in the present disclosure, the lower limit value or the upper limit value of the numerical range may be replaced by the value described in the examples. The lower limit value and the upper limit value of the numerical range may be optionally combined with the lower limit value and the upper limit value of another numerical range. In the expression "AA to BB" for the numerical range, both the end values AA and BB are included in the numerical range. The expression "more than CC to DD" for the numerical range means more than CC and DD or less.

In the present disclosure, for example, the expression "10 or more" means 10 and a value exceeding 10, and this is also applied to the cases of other values. Furthermore, for example, the expression "10 or less" means 10 and a value of less than 10, and this is also applied to the cases of other values.

As for each of the components and materials exemplified in the present disclosure, one kind thereof may be used alone, or two or more kinds thereof may be used in combination, unless otherwise indicated. In the present disclosure, in the case where multiple substances exist for each of the contents of the components in the thermosetting resin composition, the content of the component in the thermosetting resin composition means the total amount of the multiple substances existing in the thermosetting resin composition unless otherwise indicated.

In the present disclosure, the "resin component" is defined as all the components of the solid content constituting the thermosetting resin composition except for the inorganic compound, such as the inorganic filler, the flame retardant, and the flame retardant aid, which are described later.

In the present disclosure, the "solid content" means the components in the thermosetting resin composition except for the volatile substance, such as moisture and a solvent, which is described later. Accordingly, the solid content encompasses a material in the form of liquid, viscous paste, or wax around 25°C, and does not necessarily mean a solid matter.

In the present disclosure, in the case where XX is capable of being reacted, the expression "containing XX" encompasses both the case where reacted XX is contained, and the case where XX is simply contained.

In the present disclosure, an embodiment including an optional combination of the matters described therein is also encompassed in the present disclosure and the present embodiment.

[Prepreg]

The prepreg of the present embodiment is a prepreg including a fiber substrate having a thickness of 40 $\mu$m or more impregnated with a thermosetting resin composition, and the prepreg has in the fiber substrate an impregnated region and a non-impregnated region with the thermosetting resin composition, and has a surface waviness (Wa) of 5.0 $\mu$m or less.

The surface waviness (Wa) in the present disclosure is the arithmetic average height (Wa) that can be obtained from the waviness curve according to ISO 4287 (1997). JIS B0601 (2001) may be used instead of ISO 4287 (1997). The surface waviness (Wa) in the present disclosure can be measured in the following manner.

The shape measurement is automatically performed with the observation application of a profile analysis laser microscope "VK-X100" (available from Keyence Corporation) to provide a waviness curve according to ISO 4287 (1997) or JIS B0601 (2001). The resulting waviness curve is analyzed for the surface roughness with the analysis application thereof to calculate the surface waviness (Wa). The waviness curve herein is a curve obtained by removing the component having a wavelength of less than 80 $\mu$m from the cross sectional curve by applying a phase compensation high-pass filter $\lambda$c ($\lambda$c = 80 $\mu$m) on the cross sectional curve. The analysis region is 1,000 $\mu$m $\times$ 1,000 $\mu$m.

Even if not specified, the surface waviness (Wa) of the prepreg in the present disclosure is the surface waviness of at least one surface of the prepreg, and the "surface" herein means the surface of the prepreg that is to be adhered in the case where multiple prepregs are laminated to produce a metal-clad laminate, or the surface thereof opposite thereto. For example, the surface waviness (Wa) of at least one surface of the prepreg is preferably 5.0 $\mu$m or less, and the surface wavinesses (Wa) of both surfaces of the prepreg each are preferably 5.0 $\mu$m or less from the standpoint of the thickness accuracy of the metal-clad laminate.

The prepreg of the present embodiment has a surface waviness (Wa) of 5.0 $\mu$m or less irrespective of the use of the "fiber substrate having a thickness of 40 $\mu$m or more", which has a larger surface waviness than a thin fiber substrate. This has been realized by the method of "intentionally providing a non-impregnated region with the thermosetting resin composition within the fiber substrate of the prepreg". The method is generally difficult to employ in consideration of the ordinary technical common sense in the production of the prepreg that voids are suppressed from occurring by increasing the impregnation rate of the thermosetting resin composition in the fiber substrate as much as possible. The use of the prepreg successfully enhances the thickness accuracy of the metal-clad laminate of the present embodiment.

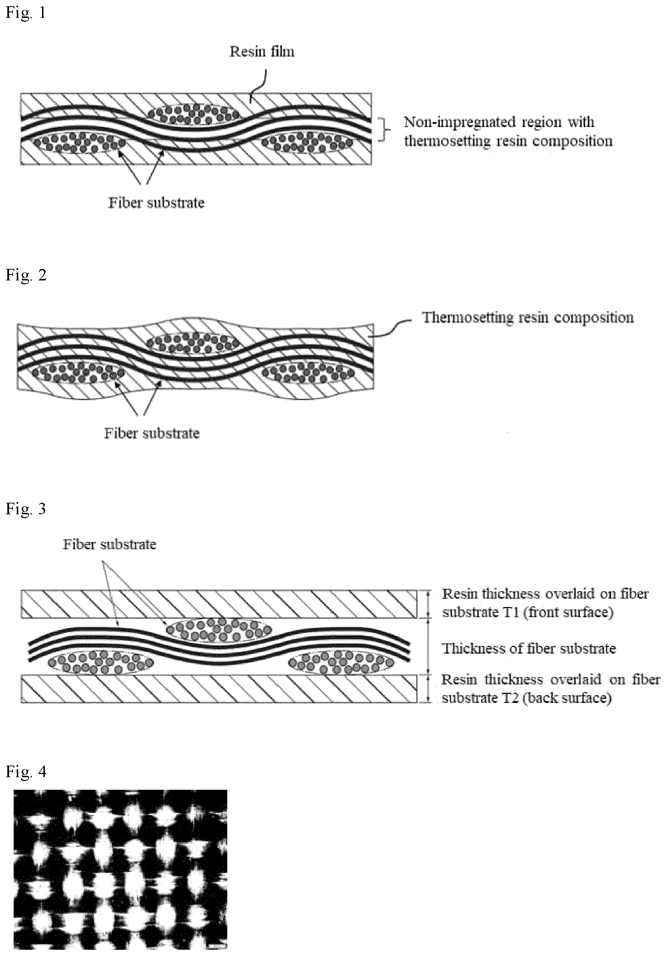

The mechanism that leads to the success is not clear, but can be considered as follows. As shown in Fig. 1, in impregnating a fiber substrate with a resin film, the region that is not impregnated with the thermosetting resin composition is intentionally provided in the fiber substrate, and thereby the layer of the thermosetting resin composition (which may be hereinafter abbreviated as a resin layer) in the vicinity of the surface is allowed to exist not along the waviness of the glass cloth. As a result, the large waviness of the fiber substrate having a thickness of 40 $\mu$m or more is prevented from appearing on the surface of the prepreg, and thereby the surface waviness (Wa) of the prepreg is allowed to be 5.0 $\mu$m or less. The use of the prepreg having a surface waviness (Wa) of 5.0 $\mu$m or less in press-molding suppresses the thickness of the metal-clad laminate from becoming uneven due to the small surface waviness (Wa) of the prepreg, resulting in the achievement of high thickness accuracy.

On the other hand, in the ordinary method of impregnating a fiber substrate with a resin varnish, followed by drying, as shown in Fig. 2, the thermosetting resin composition follows the waviness of the glass cloth, and thereby the surface waviness of the prepreg is increased. Accordingly, the thickness variation of the resin layer in the plane direction of the prepreg is increased. While the thermosetting resin composition easily flows in the thickness direction of the prepreg since the prepreg is pressurized in the thickness direction in producing a metal-clad laminate, the insufficient flow thereof in the plane direction leads to the thickness variation of the metal-clad laminate. However, there is technical difficulty in controlling the flow of the thermosetting resin composition in the plane direction to an extent that can reduce or eliminate the thickness variation of the resin layer.

The prepreg of the present embodiment has the resin layer in the vicinity of the surface thereof that exists not along the waviness of the glass cloth, and thereby has a small surface waviness, i.e., a small thickness variation, as described above. It is considered accordingly that the thickness variation of the metal-clad laminate is reduced even though the thermosetting resin composition is not allowed to flow in the plane direction in producing the metal-clad laminate.

In the present embodiment, while the non-impregnated region with the thermosetting resin composition is provided in the fiber substrate of the prepreg, voids in the metal-clad laminate can be sufficiently suppressed from occurring by allowing the thermosetting resin composition to flow in the thickness direction and run into the non-impregnated region in press molding in the production of the metal-clad laminate.

From the aforementioned standpoint, the surface waviness (Wa) of the prepreg of the present embodiment is preferably 5.0 $\mu$m or less, more preferably 3.0 $\mu$m or less, and further preferably 1.0 $\mu$m or less. The lower limit value of the surface waviness (Wa) of the prepreg of the present embodiment is not particularly limited, may be 0.01 $\mu$m or more, may be 0.1 $\mu$m or more, and may be 0.2 $\mu$m or more. Accordingly, the surface waviness (Wa) of the prepreg of the present embodiment may be 0.01 to 5.0 $\mu$m, may be 0.1 to 3.0 $\mu$m, and may be 0.2 to 1.0 $\mu$m.

(Presence of Non-impregnated Region with Thermosetting Resin Composition in Fiber Substrate)

The prepreg of the present embodiment has the impregnated region and the non-impregnated region with the thermosetting resin composition in the fiber substrate as described above, and has the particular feature that the non-impregnated region exists. The presence of the non-impregnated region can be confirmed by determining the existing ratio of the impregnated region with the thermosetting resin composition in the fiber substrate. Specifically, the existing ratio of the impregnated region that does not reach 100% means the presence of the non-impregnated region.

Examples of the method of determining the existing ratio of the impregnated region with the thermosetting resin composition in the fiber substrate include the following calculation method. From the standpoint of the thickness accuracy of the metal-clad laminate, the existing ratio of the impregnated region obtained by the following calculation method may be 25 to 98%, may be 30 to 98%, may be 30 to 95%, may be 35 to 95%, may be 35 to 90%, may be 40 to 90%, may be 40 to 85%, and may be 40 to 80%, while not particularly limited. In the case where the existing ratio is 98% or less, there is a tendency of increasing the effect of enhancing the thickness accuracy of the metal-clad laminate, and in particular, in the case where the existing ratio is 95% or less, the tendency is further enhanced. In the case where the existing ratio is 30% or more, there is a tendency that a subsidiary effect of good handleability can be obtained since powder of the thermosetting resin composition is not dropped from the prepreg.

- Calculation Method -

The surface of the prepreg is observed with an optical microscope at a magnification of 50 to provide a surface observation image. The detailed observation condition employed may be the observation condition described in the example from the standpoint of the imaging under suitable brightness.

The resulting surface observation image is converted to monochrome mode with image editing software, and saved in BMP (Microsoft Windows Bitmap Image) format. Subsequently, the surface observation image in monochrome mode saved in BMP format is converted to RGB (red, green, blue) values pixel by pixel with image converting software, and then saved in CSV (comma-separated values) format. The RGB data saved in CSV format is pasted on Microsoft Excel (available from Microsoft Corporation), and calculated for the areas of the black part (RGB value = 255) and the white part (RGB value = 0). The area ratio of the black part with respect to the total of the black part and the white part is calculated from the resulting values. The area ratio of the black part thus obtained is designated as the existing ratio of the impregnated region.

Examples of the image editing software used include Microsoft Paint (available from Microsoft Corporation). Examples of the image converting software used include bmp2csv, which is free software.

In the observation, in converting the surface observation image imaged under suitable brightness to monochrome mode, the surface having the non-impregnated region with the thermosetting resin composition existing under the observation surface is expressed in white, and the other surface is expressed in black. The surface observation image is preferably imaged with an exposure time in imaging the surface regulated to a range of 60 to 100 ms since the imaging can be performed under suitable brightness capable of sufficiently representing the impregnated region and the non-impregnated region. On the surface observation image of the prepreg, the "region having no glass cloth in the resin layer", the "region having the glass cloth sufficiently impregnated with the thermosetting resin composition", and the "region having the glass cloth insufficiently impregnated with the thermosetting resin composition" exist in descending order of the color strength. In the present embodiment, the "region having no glass cloth in the resin layer" is also encompassed in the impregnated region. In the case where the surface observation image is too bright, in the surface observation image in monochrome mode, not only the region having the glass cloth insufficiently impregnated with the resin, but also the region having the glass cloth sufficiently impregnated with resin tend to be white, and in the case where the image is further brighter, there is a tendency that the entire surface observation image in monochrome mode becomes white. On the other hand, in the case where the surface observation image is too dark, there is a tendency that the entire surface observation image in monochrome mode becomes black, and the presence of the non-impregnated region is difficult to represent. Accordingly, the imaging is preferably performed under suitable brightness. As an example of a surface observation image imaged under suitable brightness converted to monochrome mode, the surface observation image converted to monochrome mode obtained in Example 2 is shown in Fig. 4.

The area ratio of the white part with respect to the total of the black part and the white part can be easily calculated by using the COUNTIF function of Microsoft Excel (available from Microsoft Corporation).

(Surface Roughness (Ra))

The prepreg of the present embodiment preferably has a surface roughness (arithmetic average roughness: Ra, which may be hereinafter referred simply to as "Ra") of 0.1 to 5 $\mu$m, while not particularly limited.

The surface roughness (Ra) in the present disclosure is the arithmetic average height (Ra) that can be obtained from the roughness curve according to ISO 4287 (1997). JIS B0601 (2001) may be used instead of ISO 4287 (1997). The surface roughness (Ra) in the present disclosure is a surface roughness (Ra) that is obtained by measuring with a profile analysis laser microscope "VK-X100" (available from Keyence Corporation). The roughness curve measured in the present embodiment is a curve obtained by removing the component having a wavelength of more than 80 $\mu$m from the cross sectional curve by applying a phase compensation high-pass filter $\lambda$c ($\lambda$c = 80 $\mu$m) on the cross sectional curve. The analysis region is 1,000 $\mu$m $\times$ 1,000 $\mu$m.

The prepreg of the present embodiment that has Ra of 0.1 $\mu$m or more has suitable unevenness on the surface of the prepreg imparted thereby, with which the static charge amount can be suppressed low, resulting in excellent handleability. Ra of 5 $\mu$m or less can provide a tendency that the thickness accuracy of the metal-clad laminate is enhanced.

From this standpoint, Ra of the prepreg of the present embodiment may be 0.15 to 3 $\mu$m, may be 0.2 to 2 $\mu$m, may be 0.2 to 1.6 $\mu$m, and may be 0.2 to 1.0 $\mu$m.

Even if not specified, Ra of the prepreg in the present disclosure is Ra of at least one surface of the prepreg, and the "surface" herein means the surface of the prepreg that is to be adhered in the case where multiple prepregs are laminated to produce a metal-clad laminate, or the surface thereof opposite thereto. It is preferred that Ra of at least one surface of the prepreg is in the aforementioned range, and it is more preferred that Ra of both surfaces of the prepreg each are in the aforementioned range.

(Relationship of Thicknesses of Resin overlaid on Fiber Substrate on both Surfaces of Prepreg)

In the prepreg of the present embodiment, while not particularly limited, the difference between the thicknesses of the resin overlaid on the fiber substrate on both surfaces of the prepreg may be 0 to 10 $\mu$m, and thereby the warpage of the prepreg itself can be suppressed, and the warpage amount of the metal-clad laminate can be reduced. In the present disclosure, the thickness of the thermosetting resin composition overlaid on the fiber substrate on each of both surfaces of the prepreg may be referred to as a "resin thickness", and the difference between the resin thickness on one surface of the prepreg and the resin thickness on the other surface of the prepreg may be referred to as a "difference in resin thickness".

From the standpoint of reducing the warpage amount of the metal-clad laminate, the difference in resin thickness is preferably 0 to 7 $\mu$m, more preferably 0 to 5.5 $\mu$m, particularly preferably 0 to 3.5 $\mu$m, and most preferably 0 to 2.5 $\mu$m. The lower limit value of the difference in resin thickness may be 0.1 $\mu$m, may be 0.3 $\mu$m, may be 0.5 $\mu$m, and may

be 0.8 μm.

In observing the cross section of the prepreg with a metallograph as shown in Fig. 3, the resin thickness is the minimum distance from the outermost surface of the resin to the glass cloth on each of both surfaces of the prepreg in the observation image. In Fig. 3, the thermosetting resin composition with which the fiber substrate is impregnated is not shown for convenience.

It is estimated that the reduction of the difference in resin thickness overlaid on the fiber substrate as shown above reduces the difference in thermal expansion amount between surfaces of the prepreg in press molding, resulting in a tendency that the warpage of the metal-clad laminate produced therewith is prevented from occurring. The reduction of the warpage amount of the metal-clad laminate contributes to the enhancement of the connection reliability of the printed wiring board and the semiconductor package.

<Fiber Substrate>

The fiber substrate having a thickness of 40 μm or more included in the prepreg used in the present embodiment may be a known one used in various laminates for an electric insulating material. Examples of the material of the fiber substrate include natural fibers, such as paper and cotton linters; inorganic fibers, such as glass fibers and asbestos; organic fibers, such as aramid, polyimide, polyvinyl alcohol, polyester, tetrafluoroethylene, and acrylic; and mixtures thereof. Among these, inorganic fibers are preferred, and glass fibers are more preferred, from the standpoint of the flame retardancy. Examples of the glass fibers include a glass cloth using E glass, C glass, D glass, S glass, or the like; a glass cloth obtained by binding short fibers with a binder; and a mixed paper of glass fibers and cellulose fibers. Among these, the glass fibers are preferably a glass cloth using E glass.

The shape of the fiber substrate is not particularly limited, and may be a woven fabric, a nonwoven fabric, a roving, a chopped strand mat, a surfacing mat, or the like. Among these, the use of a woven fabric provides a tendency that the effects of the present embodiment can be more conspicuous. The material and the shape thereof may be appropriately selected depending on the purpose and the capabilities of the target molded article. One kind of the fiber substrate may be used alone, or two or more kinds of materials and two or more kinds of shapes may be used in combination depending on necessity.

The fiber substrate may be a fiber substrate formed of one layer, or may be a fiber substrate including multiple layers. The fiber substrate formed of one layer means a fiber substrate that is formed only of entangled fibers, and the case where a fiber substrate having no entanglement exists is classified into the fiber substrate including multiple layers. The materials and the shapes of the two or more layers of the fiber substrate each may be the same as or different from each other.

(Thickness of Fiber Substrate)

The thickness of the fiber substrate included in the prepreg of the present embodiment (see Fig. 3) is set to "40 μm or more", at which there is a tendency that the thickness accuracy of the metal-clad laminate is deteriorated by the ordinary method. The thickness of the fiber substrate may be 40 to 120 μm, may be 50 to 120 μm, may be 60 to 120 μm, may be 70 to 120 μm, or may be 70 to 100 μm. The fiber substrate tends to have a larger surface waviness by itself when the thickness of the fiber substrate is larger, and therefore the thickness accuracy of the metal-clad laminate is deteriorated by the ordinary method. However, the prepreg of the present embodiment has a surface waviness (Wa) that is suppressed small even though the thickness of the fiber substrate is large as shown above. As a result, the thickness accuracy of the metal-clad laminate is enhanced.

In the present disclosure, the thickness of the fiber substrate is the thickness of the position shown in Fig. 3, and is an average value of values obtained by measuring optional 5 positions of the fiber substrate with a micrometer.

(Surface Waviness (Wa) of Fiber Substrate)

The surface waviness (Wa) of the fiber substrate included in the prepreg of the present embodiment is not particularly limited, may be more than 5.0 μm, may be 6.0 μm or more, may be 7.0 μm or more, may be 10.0 μm or more, and may be 15.0 μm or more. The upper limit value of the surface waviness (Wa) of the fiber substrate of the present embodiment is not particularly limited, may be 40 μm or less, may be 30 μm or less, and may be 25 μm or less. Accordingly, the surface waviness (Wa) of the fiber substrate may be more than 5.0 to 40 μm, may be 6.0 to 30 μm, may be 7.0 to 30 μm, may be 10 to 25 μm, and may be 15 to 25 μm.

According to the present embodiment, even though the surface waviness (Wa) of the fiber substrate is in the aforementioned range, the surface waviness (Wa) of the prepreg can be suppressed to the aforementioned range, and the high thickness accuracy of the metal-clad laminate can be retained.

<Thermosetting Resin Composition>

The prepreg of the present embodiment is a prepreg including a fiber substrate having a thickness of 40 μm or more impregnated with a thermosetting resin composition as described above. The thermosetting resin composition contains at least a thermosetting resin. The components contained in the thermosetting resin composition are not particularly limited, and preferably include, in addition to the thermosetting resin, at least one selected from the group consisting of a curing agent, a curing accelerator, an inorganic filler, an organic filler, a coupling agent, a leveling agent, an antioxidant, a flame retardant, a flame retardant aid, a thixotropy imparting agent, a thickener, a flexible material, a surfactant, and a photopolymerization initiator.

The components contained in the thermosetting resin composition will be described below.

(Thermosetting Resin)

Examples of the thermosetting resin include an epoxy resin, a polyimide resin, a maleimide resin, a modified maleimide resin, a phenol resin, a polyphenylene ether resin, a bismaleimide-triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Examples of the modified maleimide resin include a reaction product of a maleimide compound having at least two N-substituted maleimide groups and at least one kind of a compound selected from the group consisting of a monoamine compound and a diamine compound. The thermosetting resin is not particularly limited to these resins, and known thermosetting resins may be used. One kind of the thermosetting resin may be used alone, or two or more kinds thereof may be used in combination.

Among these, from the standpoint of the moldability and the electric insulating capability, the thermosetting resin preferably contains at least one kind selected from the group consisting of an epoxy resin, a polyimide resin, a maleimide resin, a modified maleimide resin, a cyanate resin, a polyphenylene ether resin, and a bismaleimide-triazine resin.

The epoxy resin is preferably an epoxy resin having two or more epoxy groups in one molecule. The epoxy resin herein is classified into a glycidyl ether type epoxy resin, a glycidyl amine type epoxy resin, a glycidyl ester type epoxy resin, and the like. Among these, a glycidyl ether type epoxy resin is preferred.

The epoxy resin is classified into various epoxy resins depending on the difference in main skeleton. For example, the aforementioned types of epoxy resins each are classified into a bisphenol type epoxy resin, an alicyclic epoxy resin, an aliphatic linear epoxy resin, a novolac type epoxy resin, a stilbene type epoxy resin, a naphthalene skeleton-containing epoxy resin, a biphenyl type epoxy resin, a xylylene type epoxy resin, a dihydroanthracene type epoxy resin, and the like. One kind of the epoxy resin may be used alone, or two or more kinds thereof may be used in combination from the standpoint of the insulation reliability and the heat resistance.

The epoxy resin may be a novolac type epoxy resin or may be a phenol-novolac type epoxy resin.

(Curing Agent)

For example, in the case where the thermosetting resin contains an epoxy resin, examples of the curing agent include a curing agent for an epoxy resin, such as a phenol-based curing agent, a cyanate ester-based curing agent, an acid anhydride-based curing agent, an amine-based curing agent, and an active ester group-containing compound. In the case where the thermosetting resin contains a resin other than an epoxy resin, a known curing agent for that thermosetting resin may be used. One kind of the curing agent may be used alone, or two or more kinds thereof may be used in combination.

Preferred examples of the phenol-based curing agent include a cresol-novolac type phenol resin, a biphenyl-aralkyl type phenol resin, a phenol-novolac type phenol resin, a naphthylene ether type phenol resin, and triazine skeleton-containing phenol resin, while not particularly limited.

Examples of the cyanate ester-based curing agent include bisphenol A dicyanate and polyphenyl cyanate (oligo(3-methylene-1,5-phenylenecyanate)), while not particularly limited.

Examples of the acid anhydride-based curing agent include phthalic anhydride, tetrahydrophthalic anhydride, trimellitic anhydride, and pyromellitic anhydride, while not particularly limited.

Examples of the amine-based curing agent include an aliphatic amine, such as triethylenetetramine and tetraethylenepentamine, and an aromatic amine, such as 4,4'-diaminodiphenylmethane, while not particularly limited.

A urea resin and the like may also be used as the curing agent.

In the case where the thermosetting resin composition contains the curing agent, the content thereof is preferably 20 to 200 parts by mass, more preferably 20 to 150 parts by mass, and further preferably 30 to 100 parts by mass, per 100 parts by mass of the thermosetting resin.

In the case where the thermosetting resin composition contains the curing agent, the content thereof may also be expressed in terms of functional group equivalent. Specifically, the content of the curing agent preferably satisfies the expression, ((mass of thermosetting resin)/(functional group equivalent)) ≈ ((mass of curing agent)/(functional group equivalent capable of reacting to thermosetting resin)) × constant C. The constant C varies depending on the kind of the functional group of the curing agent, and is preferably 0.8 to 1.2 for the case where the functional group is a phenolic hydroxy group, preferably 0.2 to 0.4 for the case where the functional group is an amino group, and preferably 0.3 to 0.6 for the case where the functional group is an active ester group.

In the case where the thermosetting resin contains an epoxy resin, the expression is ((mass of epoxy resin)/(epoxy group equivalent)) ≈ ((mass of curing agent)/(functional group equivalent capable of reacting to epoxy group)) × constant C.

(Curing Accelerator)

The curing accelerator used may be an ordinary curing accelerator having been used for curing the thermosetting resin. For example, in the case where the thermosetting resin contains an epoxy resin, examples of the curing accelerator include an imidazole compound and a derivative thereof, a phosphorus compound, a tertiary amine compound, and a quaternary ammonium compound. An imidazole compound and a derivative thereof are preferred from the standpoint of accelerating the curing reaction.

Specific examples of the imidazole compound and a derivative thereof include an imidazole compound, such as 2-methylimidazole, 2-ethylimidazole, 2-undecylimidazole, 2-phenylimidazole, 1,2-dimethylimidazole, and 2,4-diamino-6-[2'-methylimidazolyl-(1')]ethyl-s-triazine; a salt of the imidazole compound and trimellitic acid, such as 1-cyanoethyl-2-phenylimidazolium trimellitate; a salt of the imidazole compound and isocyanuric acid; and a salt of the imidazole compound and hydrobromic acid. One kind of the imidazole compound may be used alone, or two or more kinds thereof may be used in combination.

The curing accelerator may be an imidazole compound and a derivative thereof, or may be an imidazole compound.

In the case where the thermosetting resin composition contains the curing accelerator, the content thereof is preferably 0.1 to 20 parts by mass, and more preferably 0.1 to 10 parts by mass, per 100 parts by mass of the thermosetting resin.

(Inorganic Filler)

An inorganic filler can reduce the thermal expansion coefficient and can enhance the coating film strength.

Examples of the inorganic filler include silica, alumina, barium sulfate, talc, mica, kaolin, boehmite, beryllia, barium titanate, potassium titanate, strontium titanate, calcium titanate, aluminum carbonate, magnesium hydroxide, aluminum hydroxide, aluminum borate, aluminum silicate, calcium carbonate, calcium silicate, magnesium silicate, zinc borate, zinc stannate, aluminum oxide, zirconia, mullite, magnesia, zinc oxide, titanium oxide, silicon carbide, silicon nitride, boron nitride, clay (such as baked clay), a molybdic acid compound, such as zinc molybdate, glass short fibers, glass powder, and hollow glass beads. Preferred examples of the glass as the material of glass short fibers, glass powder, and hollow glass beads include E glass, T glass, and D glass. One kind of the inorganic filler may be used alone, or two or more kinds thereof may be used in combination. Among these, from the standpoint of reducing the thermal expansion coefficient and reducing the relative permittivity and the dielectric tangent, silica and alumina are preferred, and from the standpoint of the heat resistance, aluminum hydroxide is preferred, and silica and aluminum hydroxide are more preferred.

Examples of the silica include precipitated silica having a high water content produced by the wet method and dry method silica containing substantially no combined water or the like produced by the dry method. Examples of the dry method silica include crushed silica, fumed silica, and fused silica (molten spherical silica), which are classified by the difference in production method.

The inorganic filler may be subjected to a surface treatment with a surface treating agent, such as a silane coupling agent, for enhancing the moisture resistance, and may be subjected to a hydrophobizing treatment for enhancing the dispersibility.

In the case where the thermosetting resin composition contains the inorganic filler, the content thereof is preferably 0.1 to 65% by volume while varying depending on the purpose of the addition thereof. With the content of 0.1% by volume or more, there is a tendency that the thermal expansion coefficient can be reduced. By suppressing the content to 65% by volume or less, on the other hand, there is a tendency that the viscosity in mixing the resin component does not become too high, and the deterioration in workability can be easily suppressed from occurring. From the same standpoint, the content of the inorganic filler is more preferably 10 to 60% by volume, further preferably 15 to 55% by volume, and particularly preferably 30 to 55% by volume.

(Coupling Agent)

A coupling agent contained can provide an effect of enhancing the dispersibility of the inorganic filler and the organic filler and enhancing the adhesiveness to the reinforcing base and the metal foil. One kind of the coupling agent may be used alone, or two or more kinds thereof may be used in combination.
The coupling agent may be a titanate coupling agent, a silane coupling agent, or the like.

(Organic Solvent)

The thermosetting resin composition may further contain an organic solvent from the standpoint of enhancing the handleability. In the present disclosure, the thermosetting resin composition that contains an organic solvent may be referred to as a resin varnish.
Examples of the organic solvent include an alcohol-based solvent, such as methanol, ethanol, methyl cellosolve, butyl cellosolve, and propylene glycol monomethyl ether; a ketone-based solvent, such as acetone, methyl ethyl ketone, methyl isobutyl ketone, butanone, cyclohexanone, and 4-methyl-2-pentanone; an ester-based solvent, such as ethyl acetate, butyl acetate, and propylene glycol monomethyl ether acetate; an ether-based solvent, such as tetrahydrofuran; an aromatic-based solvent, such as toluene, xylene, and mesitylene; a nitrogen atom-containing solvent, such as N,N-dimethylformamide, N,N-dimethylacetamide, and N-methylpyrrolidone; a sulfur atom-containing solvent, such as dimethylsulfoxide; and an ester-based solvent, such as $\gamma$-butyrolactone, while not particularly limited.
One kind of the organic solvent may be used alone, or two or more kinds thereof may be used in combination.
For example, the content of the organic solvent is regulated to make a non-volatile content concentration of preferably 20 to 85% by mass, and more preferably 40 to 80% by mass, from the standpoint of facilitating the coatability.
However, while a resin varnish may be prepared by using the organic solvent, the method of producing a prepreg of the present embodiment described later provides a prepreg in such a manner that a resin film is produced, and then the fiber substrate is impregnated with the resin film, and therefore the organic solvent is vaporized in the stage of producing the resin film. As a result, the prepreg of the present embodiment contains substantially no organic solvent remaining, and specifically the content thereof may be 5% by mass or less.
The method of preparing the thermosetting resin composition is not particularly limited, and an ordinarily known preparing method may be used.
For example, the thermosetting resin and depending on necessity the additional components are added to the organic solvent, which are then mixed and agitated with a mixer, so as to provide the resin varnish. Examples of the mixer include mixers of an ultrasonic dispersion type, a high-speed collision dispersion type, a high-speed rotation dispersion type, a bead mill type, a high-speed shear dispersion type, and a planetary centrifugal dispersion type.

(Thickness of Prepreg)

The thickness of the prepreg of the present embodiment can be appropriately determined depending on the thickness of the fiber substrate and the like, may be 50 to 300 $\mu$m, may be 50 to 250 $\mu$m, may be 55 to 200 $\mu$m, may be 60 to 180 $\mu$m, may be 60 to 170 $\mu$m, and may be 60 to 150 $\mu$m. The thickness of the prepreg herein means the thickness of one ply of the prepreg. In the case where the thickness of the prepreg is the lower limit value or more, there is a tendency that the effect of reducing the surface waviness by the present embodiment is enhanced. In the case where the thickness of the prepreg is the upper limit value or less, there is a tendency that voids are suppressed from occurring after the production of the laminate in the present embodiment.
In the present disclosure, the thickness of the prepreg is an average value of values obtained by measuring optional 5 positions of the prepreg with a digimatic indicator.

[Method of producing Prepreg]

The method of producing the prepreg of the present embodiment is not particularly limited, and is preferably the following production method from the standpoint of enhancing the thickness accuracy.
Specifically, the method is preferably a method of producing a prepreg having a surface waviness (Wa) of 5.0 $\mu$m or less, including impregnating a fiber substrate having a thickness of 40 $\mu$m or more with a film of a thermosetting resin composition through lamination, the method of producing a prepreg including providing in the fiber substrate an impregnated region and a non-impregnated region with the thermosetting resin composition.
In the production method, a film of a thermosetting resin composition (which may be hereinafter referred to as a "resin film") is used. A method of impregnating a fiber substrate with a resin varnish, followed by drying, is difficult to provide the non-impregnated region intentionally in the fiber substrate, resulting in a tendency that the surface waviness (Wa) is also increased (see Fig. 2), and therefore the aforementioned production method is preferred.

In the method of producing a prepreg described above, the fiber substrate, the thermosetting resin composition, and the surface waviness (Wa) have been described above.

The resin film can be produced by forming a layer of the thermosetting resin composition (resin layer) on one surface of a release film. The resin layer can be formed, for example, by coating the resin varnish on one surface of a release film and then drying.

The method of coating the resin varnish is not particularly limited, and can be performed, for example, by using a known coating device, such as a comma coater, a bar coater, a kiss coater, a roll coater, a gravure coater, and a die coater. The coating device is preferably selected appropriately in consideration of the thickness of the resin layer.

The drying temperature and the drying time may vary depending on the amount of the organic solvent used and the boiling point of the organic solvent, and for example, in the case of the resin varnish containing 30 to 70% by mass of the organic solvent, the resin film can be favorably formed by drying at 50 to 160°C for 1 to 8 minutes.

The film formed in this manner may be referred to as a resin film with a release film.

(Thickness of Resin Film)

The thickness of the resin film may be appropriately determined depending on the thickness of the prepreg and the like. For example, in the case where the thickness of the fiber substrate is in a range of 40 to 120 μm, the thickness of the resin film is preferably 10 to 100 μm, more preferably 15 to 70 μm, and further preferably 20 to 50 μm. In the present disclosure, the thickness of the resin film is a value that is measured in the following manner. The total thickness of the film with the resin after coating is measured at optional 5 positions with a digimatic indicator. At each of the measured positions, after removing the resin layer with an adhesive tape, the thickness of the release film is measured with a digimatic indicator, and the values obtained by subtracting the thickness of the release film from the total thickness are averaged.

In the case where the thickness of the resin film is the lower limit value or more, there is a tendency that the amount of the resin for impregnating a thick glass cloth having a thickness of 40 μm or more can be sufficiently secured. In the case where the thickness of the resin film is the upper limit value or less, there is a tendency that the resin film can be easily produced.

(Release Film)

Examples of the release film include an organic film, such as polyethylene terephthalate (PET), biaxially stretched polypropylene (OPP), polyethylene, polyvinyl fluoride, and polyimide; and a metal or alloy film, such as copper and aluminum. The release film may be subjected to a release treatment with a release agent.

The thickness of the release film is not particularly limited, and is preferably 10 to 200 μm, more preferably 20 to 100 μm, and further preferably 30 to 70 μm, from the standpoint of the handleability in coating the thermosetting resin composition and the economic efficiency.

A commercially available product may also be used as the release film.

(Method of impregnating Fiber Substrate with Resin Film)

A method of impregnating the fiber substrate with the resin film through lamination will be then described.

The resin film with the release film is disposed on at least one surface of the fiber substrate in such a manner that the resin film is brought into contact with the fiber substrate. Thereafter, the resin film with the release film thus disposed and the fiber substrate are heated and pressurized, and thereby the fiber substrate is impregnated with the resin film. At this time, the non-impregnated region with the thermosetting resin composition is provided in the fiber substrate. The prepreg of the present embodiment with the release film is thus obtained in this manner.

The heating and pressurizing herein is preferably performed through lamination. Examples of the method of the lamination include roll lamination (a) and a lamination method under reduced pressure (b), such as a vacuum lamination method.

While the condition of the roll lamination (a) is not particularly limited, the heating temperature is preferably 80 to 180°C, and the pressurizing pressure is preferably 0.05 to 1.0 MPa/m.

While the condition of the lamination method under reduced pressure (b) is not particularly limited, the heating temperature is preferably 50 to 170°C, and more preferably 110 to 160°C, the pressurizing time is preferably 10 to 120 seconds, and more preferably 20 to 80 seconds, and the pressurizing pressure is preferably 0.05 to 1.0 MPa, and more preferably 0.1 to 0.6 MPa.

(Method of providing Non-impregnated Region)

Examples of the method of providing the non-impregnated region with the thermosetting resin composition in the fiber substrate include a method of regulating the condition in heating and pressurizing the resin film with the release film and the fiber substrate, while not particularly limited. Specific examples thereof include a method of regulating the lamination condition.

In the case where the same lamination condition is applied to the case of a thin fiber substrate and the case of a thick fiber substrate, the case of a thick fiber substrate has a tendency that the fiber substrate is more difficult to impregnate with the resin film. Therefore, even in the case where the lamination condition in the present embodiment is equivalent to the condition in laminating the resin film with the ordinary thin fiber substrate, the non-impregnated region with the thermosetting resin composition can be provided in the fiber substrate in the present embodiment.

Examples of the method of regulating the condition in heating and pressurizing include the following method, while not particularly limited. A prepreg is produced in advance under the prescribed heating and pressurizing condition, and the existing ratio of the impregnated region with the thermosetting resin composition in the fiber substrate is obtained based on the calculation method described above. As a result, in the case where the impregnated region is 100%, i.e., there is no non-impregnated region, a prepreg is again produced by decreasing the heating temperature or decreasing the pressurizing pressure, or by decreasing both the heating temperature and the pressurizing pressure, and the existing ratio of the impregnated region is again obtained. The procedure is repeated depending on necessity, and thereby the condition for producing the prepreg having the non-impregnated region can be easily comprehended.

In the case where the existing ratio of the non-impregnated region is to be regulated lower, a prepreg is again produced by increasing the heating temperature or increasing the pressurizing pressure, or by increasing both the heating temperature and the pressurizing pressure.

In the case where the lamination is performed under reduced pressure, the existing ratio of the non-impregnated region can also be regulated by regulating the vacuum degree.

It is preferred that one or more plies of the resin film is disposed and laminated on each of both surfaces of the fiber substrate. The number of plies of the resin film is preferably one or two, and more preferably one, per one surface of the fiber substrate.

After impregnating the fiber substrate with the resin film, the resulting prepreg with the release film is cooled depending on necessity, and then the release film is released therefrom to produce the prepreg having a surface waviness (Wa) of 5.0 $\mu$m or less.

[Laminate and Metal-clad Laminate]

The present disclosure also provides a laminate including one or more plies of the prepreg of the present embodiment. The laminate that has a metal foil disposed therein is referred particularly to as a "metal-clad laminate". Accordingly, the present disclosure also provides a metal-clad laminate including a metal foil and one or more plies of the prepreg of the present embodiment. The prepreg of the present embodiment may be used in combination with another prepreg. In the laminate and the metal-clad laminate of the present embodiment, the number of plies of the prepreg may be 1 to 20, may be 2 to 20, may be 5 to 18, and may be 8 to 16, as long as one or more plies of the prepreg of the present embodiment are included.

Examples of the metal foil included in the metal-clad laminate include a copper foil, an aluminum foil, a tin foil, a tin-lead alloy (solder) foil, and a nickel foil. The thickness of the metal foil may be a thickness that has been ordinarily used in laminates, and for example, 1 to 200 $\mu$m. A composite foil having a three-layer structure including an intermediate layer, such as nickel, nickel-phosphorus, a nickel-tin alloy, a nickel-iron alloy, lead, or a lead-tin alloy, having on both surfaces thereof a copper layer of 0.5 to 15 $\mu$m and a copper layer of 10 to 300 $\mu$m, and a composite foil having a two-layer structure including aluminum and a copper foil may also be used.

In the case where the metal foil is a copper foil, the metal-clad laminate is referred to as a copper-clad laminate.

[Method of producing Metal-clad Laminate]

The present disclosure also provides a method of producing a metal-clad laminate, including disposing metal foils on both surfaces of one ply of the prepreg of the present embodiment, or on both surfaces of a prepreg laminate including one or more plies of the prepreg of the present embodiment, and then press-molding. Specific examples of the method of press-molding include a method of press-molding under conditions of a vacuum degree of preferably 300 kPa or less, and more preferably 100 kPa or less, a temperature of preferably 130 to 350°C, more preferably 150 to 300°C, and further preferably 170 to 250°C, and a pressure of preferably 0.5 to 10 MPa, and more preferably 1 to 5 MPa, with a vacuum press. The press molding allows the thermosetting resin composition to flow into the non-impregnated region with the thermosetting resin composition in the fiber substrate, and as a result, voids can be suppressed from occurring.

It is preferred that 10% by mass or more of the prepreg laminate is constituted by the prepreg of the present embodiment, it is more preferred that 20% by mass or more thereof is constituted by the prepreg of the present embodiment, it is further preferred that 50% by mass or more thereof is constituted by the prepreg of the present embodiment, and the entire thereof may be constituted by the prepreg of the present embodiment, from the standpoint of achieving the copper-clad laminate having high thickness accuracy, while not particularly limited. Even in the case where less than 10% by mass of the prepreg laminate is constituted by the prepreg of the present embodiment, the prepreg contributes to the enhancement of the thickness accuracy of the copper-clad laminate.

The metal foil is removed from the metal-clad laminate of the present embodiment by an etching treatment or the like, and thereby the laminate of the present embodiment can be obtained.

[Printed Wiring Board]

The present disclosure also provides a printed wiring board including the laminate of the present embodiment or the metal-clad laminate of the present embodiment. In other words, the present disclosure also provides a printed wiring board obtained by forming a wiring pattern on the laminate of the present embodiment or the metal-clad laminate of the present embodiment.

The printed wiring board of the present embodiment can be produced by forming a wiring pattern on the laminate of the present embodiment or the metal-clad laminate of the present embodiment. Examples of the method of forming a wiring pattern include known processes, such as a subtractive process, a full additive process, a semi-additive process (SAP), and a modified semi-additive process (m-SAP).

[Semiconductor Package]

The present disclosure also provides a semiconductor package including the printed wiring board of the present embodiment and a semiconductor device. The semiconductor package of the present embodiment can be produced, for example, in such a manner that semiconductor devices, such as a semiconductor chip and a memory chip, are mounted on the prescribed positions on the printed wiring board of the present embodiment, and then the semiconductor devices are encapsulated with an encapsulating resin or the like.

Examples

The present embodiment will be described in more detail with reference to examples below, but the examples do not limit the present embodiment.

The prepregs and the copper-clad laminates produced in the examples were evaluated in the following manner.

[1. Surface Waviness (Wa)]

The prepreg produced in each of the examples was measured for the surface waviness (Wa). The shape measurement was automatically performed with the observation application of a profile analysis laser microscope "VK-X100" (available from Keyence Corporation) to provide a waviness curve according to ISO 4287 (1997). The resulting waviness curve was analyzed for the surface roughness with the analysis application thereof to calculate the surface waviness (Wa). The waviness curve herein is a curve obtained by removing the component having a wavelength of less than 80 $\mu$m from the cross sectional curve by applying a phase compensation high-pass filter $\lambda$c ($\lambda$c = 80 $\mu$m) on the cross sectional curve. The analysis region was 1,000 $\mu$m $\times$ 1,000 $\mu$m.

The surface waviness (Wa) was measured for both surfaces of the prepreg, and the larger value was used.

[2. Surface Roughness (Ra)]

The prepreg produced in each of the examples was measured for the surface roughness (Ra). The shape measurement was automatically performed with the observation application of a profile analysis laser microscope "VK-X100" (available from Keyence Corporation) to provide a roughness curve according to ISO 4287 (1997). The resulting roughness curve was analyzed for the surface roughness with the analysis application thereof to calculate the surface roughness (Ra). The roughness curve herein is a curve obtained by removing the component having a wavelength of more than 80 $\mu$m from the cross sectional curve by applying a phase compensation high-pass filter $\lambda$c ($\lambda$c = 80 $\mu$m) on the cross sectional curve. The analysis region was 1,000 $\mu$m $\times$ 1,000 $\mu$m.

The surface roughness (Ra) was measured for both surfaces of the prepreg, and the larger value was used.

[3. Existing Ratio of Impregnated Region]

The existing ratio (%) of the impregnated region with the thermosetting resin composition in the fiber substrate was obtained by the following calculation method.

- Calculation Method -

The surface of the prepreg was observed with an optical microscope (MX61L-F, trade name, available from Olympus Corporation) under the following condition to provide a surface observation image.

<Observation Condition>

Magnification: 50
Observation mode: dark field
Speed: ISO 400
Exposure time in surface imaging: 60 to 100 ms
Brightness of observation environment: two 35 W fluorescent light tubes disposed 2 m above observation stage

The resulting surface observation image was converted to monochrome mode with image editing software, and saved in BMP (Microsoft Windows Bitmap Image) format. Subsequently, the surface observation image in monochrome mode saved in BMP format was converted to RGB (red, green, blue) values pixel by pixel with image converting software, and then saved in CSV (comma-separated values) format. The RGB data saved in CSV format was pasted on Microsoft Excel (available from Microsoft Corporation), and calculated for the areas of the black part (RGB value = 255) and the white part (RGB value = 0). The area ratio of the black part with respect to the total of the black part and the white part was calculated from the resulting values. The area ratio of the black part thus obtained was designated as the existing ratio (%) of the impregnated region.
The surface observation image was imaged in such a manner that the impregnated region and the non-impregnated region were sufficiently identified, with suitable brightness by regulating the exposure time in surface imaging within 60 to 100 ms as described above.
The image editing software used was Microsoft Paint (available from Microsoft Corporation). The image converting software used was bmp2csv, free software.

[4. Handleability of Prepreg]

The prepreg obtained in each of the examples was cut out into a 250 mm square, which was designated as an evaluation specimen. The evaluation specimen was folded along one diagonal line thereof by 180°, and then returned to the original form. In this operation, a specimen having no resin powder dropping off visually observed was evaluated as grade "A", and a specimen having resin powder dropping off visually observed was evaluated as grade "B". The grade "A" means excellent handleability.

[5. Difference in Thickness of Resin overlaid on Fiber Substrate on both Surfaces of Prepreg (Difference in Resin Thickness between both Surfaces)]

The prepreg obtained in each of the examples was dried at 170°C for 1 hour, and then further dried at 200°C for 1 hour, with an explosion-proof dryer.
The dried prepreg was cast molded with an epoxy resin, and the cross sectional part thereof was observed with a metallograph and measured for the difference in thickness of the resin overlaid on the fiber substrate between both surfaces of the prepreg. As shown in Fig. 3, the minimum distance from the outermost surface of the resin to the glass cloth on the front surface of the prepreg was designated as T1, and the minimum distance from the outermost surface of the resin to the glass cloth on the back surface of the prepreg was designated as T2. The absolute value of the difference between T1 and T2 was designated as the difference in resin thickness.

[6. Thickness Variation of Copper-clad Laminate]

The copper-clad laminate obtained in each of the examples was measured for the thickness at 10 positions from the center in the width direction of the laminate every 50 mm in the width direction, and 10 positions from each of the 10 positions as starting points in the length direction every 50 mm (which were 10 positions including the starting points, i.e., the number of measured positions was $10 \times 10 = 100$ positions). Specifically, the thickness was measured with a horizontal pedestal and a digimatic indicator "ID-C112P" (available from Mitutoyo Corporation) in 0.001 mm. The value obtained by the following expression was designated as the index of thickness variation. A smaller value thereof means a smaller thickness variation, and thus shows excellent thickness accuracy.

$$\text{Thickness variation (\%)} = 100 \times (((\text{maximum value of thickness})-(\text{average value of thickness}))/(\text{average value of thickness}))$$

[7. Solder Heat Resistance of Copper Clad]

The copper-clad laminate obtained in each of the examples was cut out into a 25 mm square to produce an evaluation board. The evaluation board was floated on a solder bath at a temperature of 288°C for 60 minutes at most, and the appearance thereof was visually observed to measure the period of time until blister occurred. The case where no blister was confirmed after floating for 60 minutes was shown as "> 60". A longer period of time until blister occurred means excellent solder heat resistance of copper clad.

[8. Warpage Amount of Copper-clad Laminate]

The copper-clad laminate for evaluating warpage amount obtained in each of the examples was cut out into a 250 mm square to produce an evaluation board. The evaluation board was placed horizontally on a measurement pedestal, and measured for the warpage amount. The height from the measurement pedestal of the corner of the evaluation board that most warped among the four corners thereof was used as the warpage amount.
The case where the warpage of the copper-clad laminate was 10 mm or less was evaluated as grade A, and the case where the warpage thereof exceeded 10 mm was evaluated as grade B.

Reference Example 1

The following glass cloths were measured for the surface waviness (Wa) in the same manner as in [1. Surface Waviness (Wa)] above, and the glass cloths having various thicknesses were compared for the surface waviness (Wa). The thicknesses of the glass cloths below each were the average value of values obtained by measuring optional 5 positions with a micrometer "MDC-25MX" (available from Mitutoyo Corporation).

<Glass Cloth having Thickness of 40 $\mu$m or more>

(i) Glass cloth "IPC #2116" (available from Nitto Boseki Co., Ltd., basis weight: 104 g/m$^2$, substrate width: 530 mm, thickness: 91 $\mu$m)
(ii) Glass cloth "IPC #3313" (available from Nitto Boseki Co., Ltd., basis weight: 82 g/m$^2$, substrate width: 530 mm, thickness: 73 $\mu$m)
(iii) Glass cloth "IPC #1078" (available from Nitto Boseki Co., Ltd., basis weight: 47 g/m$^2$, substrate width: 530 mm, thickness: 44 $\mu$m)

<Glass Cloth having Thickness of less than 40 $\mu$m>

(iv) Glass cloth "IPC #1037" (available from Nitto Boseki Co., Ltd., basis weight: 24 g/m$^2$, substrate width: 530 mm, thickness: 24 $\mu$m)
(v) Glass cloth "IPC #1027" (available from Nitto Boseki Co., Ltd., basis weight: 20 g/m$^2$, substrate width: 530 mm, thickness: 21 $\mu$m)

The glass cloths "IPC #2116", "IPC #3313", and "IPC #1078" had surface wavinesses (Wa) of 21.9 $\mu$m, 13.4 $\mu$m, and 7.3 $\mu$m, respectively.
The glass cloths "IPC #1037" and "IPC #1027" had surface wavinesses (Wa) of 4.7 $\mu$m and 4.5 $\mu$m, respectively.

It is understood that a glass cloth having a thickness of 40 μm or more has a larger surface waviness (Wa) than a glass cloth having a thickness of less than 40 μm.

Production Example 1

(Production of Resin Varnish A)

60 parts by mass of a phenol-novolac type epoxy resin "Epiclon (registered trademark) N-770" (available from DIC Corporation, epoxy equivalent: 188 g/eq), 40 parts by mass of a biphenyl-aralkyl type phenol resin (available from Meiwa Plastic Industries, Ltd., trade name: MEH-7700), 17.5 parts by mass of aluminum hydroxide, 86 parts by mass of fused silica, 0.5 part by mass of 2-methylimidazole, and methyl isobutyl ketone and cyclohexanone as diluent solvents were added and mixed to produce a resin varnish A having a solid concentration of 65% by mass (content of aluminum hydroxide: 8% by volume, content of fused silica: 32% by volume).

Production Example 2

(1. Production of Modified Maleimide Resin)

In a reaction vessel having a capacity of 2 L capable of being heated and cooled equipped with a thermometer, an agitation device, and a water quantitative meter having a reflux condenser, 595.8 g of bis(4-maleimidophenyl)methane, 54.2 g of 4,4'-diaminodiphenylmethane, and 350.0 g of propylene glycol monomethyl ether were placed and then reacted for 5 hours under refluxing, so as to provide a solution of a modified maleimide resin.

(2. Production of Resin Varnish B)

107 parts by mass of the solution of a modified maleimide resin above, 30 parts by mass of a tetrafunctional naphthalene type epoxy resin "EXA-4710" (available from DIC Corporation), 17.5 parts by mass of aluminum hydroxide, 130 parts by mass of fused silica, 0.5 part by mass of 2,4-diamino-6-[2'-methylimidazolyl-(1')]ethyl-s-triazine, and methyl isobutyl ketone and cyclohexanone as diluent solvents were added and mixed to produce a resin varnish B having a solid concentration of 65% by mass (content of aluminum hydroxide: 8% by volume, content of fused silica: 41.5% by volume).

Example 1

(1. Production of Resin Film)

The resin varnish A obtained in Production Example 1 was coated on a PET film (available from Toyobo Film Solutions, Ltd., thickness: 50 μm, a release film, trade name: G2) with a comma coater. At this time, the coating amount was regulated to make a coating width of 530 mm and a thickness after drying of 30 μm. Thereafter, the resin varnish was dried by heating to 130°C for 2 minutes to produce a resin film with a PET film.

(2. Production of Prepreg)

The resin films with a PET film were disposed on both surfaces of a glass cloth "IPC #2116" (available from Nitto Boseki Co., Ltd., basis weight: 104 g/m$^2$, substrate width: 530 mm, thickness: 91 μm) in such a manner that the surface of the resin layer of the resin film with a PET film was brought into contact with the glass cloth. The laminate of PET film/resin film/glass cloth/resin film/PET film was heated and pressurized in vacuum with a vacuum laminator. According to the procedure, a prepreg with a PET film having the glass cloth impregnated with the thermosetting resin composition of the resin film was obtained. The condition of vacuum lamination was a heating platen temperature of 100°C, a pressurizing pressure of 0.3 MPa, a vacuum degree of 100 kPa or less, and a vacuum time of 20 seconds. The PET film was released from the resulting prepreg with a PET film, so as to provide a prepreg 1 having a thickness of 130 μm.

The thickness of the prepreg 1 was the average value of values obtained by measuring optional 5 positions with a horizontal pedestal and a digimatic indicator (available from Mitutoyo Corporation).

The content ratio of the thermosetting resin composition in the prepreg 1 was calculated in the following manner. The mass ($w_r$) of the resin film was calculated by subtracting the total mass of the two plies of the PET films from the total mass of two plies of the resin films with a PET film used in producing the prepreg 1. The content ratio of the thermosetting resin composition was obtained from the mass ($w_r$) of the resin film and the mass ($w_p$) of the prepreg 1 according to the following expression.

$$\text{Content ratio of thermosetting resin composition} = (w_r/w_p) \times 100$$

The resulting prepreg 1 was evaluated as described above. The results are shown in Table 1.

(3. Production of Copper-clad Laminate)

12 plies of the prepregs 1 were laminated, and copper foils having a thickness of 12 $\mu$m "GTS-12" (available from Furukawa Electric Co., Ltd.) were disposed on both surfaces thereof. Subsequently, the assembly was pressed under the following condition, so as to produce a copper-clad laminate 1. The resulting copper-clad laminate 1 was evaluated as described above. The results are shown in Table 1.

Separately, a copper-clad laminate for evaluating the warpage amount was produced in the following manner. On both surfaces of one ply of the prepreg 1, copper foils having a thickness of 12 $\mu$m "GTS-12" (available from Furukawa Electric Co., Ltd.) were disposed. Subsequently, the assembly was pressed under the following condition, so as to produce a copper-clad laminate 1 for evaluating the warpage amount.

- Press Condition -

Heating condition (resin varnish A): heating from 25°C to 185°C at heating rate of 3°C/min, retaining at 185°C for 90 minutes, and then cooled for 30 minutes

Pressure condition (pressure applied to 12 plies of prepregs held with copper foils): 4 MPa (from start of heating to end of cooling)

Example 2

A prepreg 2 (thickness: 125 $\mu$m) was produced by performing the same procedure as in Example 1 except that in the production of the prepreg in Example 1, the condition of the vacuum lamination was changed to a heating platen temperature of 130°C, a pressurizing pressure of 0.5 MPa, a vacuum degree of 100 kPa or less, and a vacuum time of 30 seconds. A copper-clad laminate 2 was produced by performing the same procedure as in Example 1 except that in the production of the copper-clad laminate in Example 1, the prepreg 2 was used instead of the prepreg 1. The evaluation results are shown in Table 1.

The surface observation image of the prepreg converted to monochrome mode used in calculating the existing ratio of the impregnated region is shown in Fig. 4. The observation condition of the surface of the prepreg was as described above, and the exposure time in imaging the surface was 85 ms.

Example 3

A prepreg 3 (thickness: 125 $\mu$m) was produced by performing the same procedure as in Example 2 except that in the production of the prepreg in Example 2, the resin varnish B was used instead of the resin varnish A. A copper-clad laminate 3 was produced by performing the same procedure as in Example 2 except that in the production of the copper-clad laminate in Example 2, the prepreg 3 was used instead of the prepreg 2, and the press condition was changed as shown below. The evaluation results are shown in Table 1.

- Press Condition -

Heating condition (resin varnish B): heating from 25°C to 230°C at heating rate of 3°C/min, retaining at 230°C for 90 minutes, and then cooled for 30 minutes

Example 4

A prepreg 4 (thickness: 115 $\mu$m) was produced by performing the same procedure as in Example 1 except that in the production of the prepreg in Example 1, the condition of the vacuum lamination was changed to a heating platen temperature of 150°C, a pressurizing pressure of 0.5 MPa, a vacuum degree of 100 kPa or less, and a vacuum time of 30 seconds. A copper-clad laminate 4 was produced by performing the same procedure as in Example 1 except that in the production of the copper-clad laminate in Example 1, the prepreg 4 was used instead of the prepreg 1. The evaluation results are shown in Table 1.

Example 5

A prepreg 5 (thickness: 110 μm) was produced by performing the same procedure as in Example 1 except that in the production of the prepreg in Example 1, the condition of the vacuum lamination was changed to a heating platen temperature of 150°C, a pressurizing pressure of 0.5 MPa, a vacuum degree of 100 kPa or less, and a vacuum time of 60 seconds. A copper-clad laminate 5 was produced by performing the same procedure as in Example 1 except that in the production of the copper-clad laminate in Example 1, the prepreg 5 was used instead of the prepreg 1. The evaluation results are shown in Table 1.

Example 6

A prepreg 6 (thickness: 125 μm) was produced by performing the same procedure as in Example 1 except that in the production of the resin film in Example 1, the PET film was changed to (available from Toray Industries, Inc., thickness: 50 μm, a release film, trade name: Lumirror (registered trademark) #50-X44), and in the production of the prepreg therein, the condition of the vacuum lamination was changed to a heating platen temperature of 140°C, a pressurizing pressure of 0.5 MPa, a vacuum degree of 100 kPa or less, and a vacuum time of 40 seconds. A copper-clad laminate 6 was produced by performing the same procedure as in Example 1 except that in the production of the copper-clad laminate in Example 1, the prepreg 6 was used instead of the prepreg 1. The evaluation results are shown in Table 1.

Example 7

A prepreg 7 (thickness: 105 μm) was produced by performing the same procedure as in Example 2 except that in the production of the prepreg in Example 2, the glass cloth "IPC #2116" was changed to a glass cloth "IPC #3313" (available from Nitto Boseki Co., Ltd., basis weight: 82 g/m², substrate width: 530 mm, thickness: 73 μm). A copper-clad laminate 7 was produced by performing the same procedure as in Example 2 except that in the production of the copper-clad laminate in Example 2, the prepreg 7 was used instead of the prepreg 2. The evaluation results are shown in Table 1.

Example 8

A prepreg 8 (thickness: 105 μm) was produced by performing the same procedure as in Example 3 except that in the production of the prepreg in Example 3, the glass cloth "IPC #2116" was changed to a glass cloth "IPC #3313" (available from Nitto Boseki Co., Ltd., basis weight: 82 g/m², substrate width: 530 mm, thickness: 73 μm). A copper-clad laminate 8 was produced by performing the same procedure as in Example 3 except that in the production of the copper-clad laminate in Example 3, the prepreg 8 was used instead of the prepreg 3. The evaluation results are shown in Table 1.

Example 9

A prepreg 9 (thickness: 70 μm) was produced by performing the same procedure as in Example 2 except that in the production of the resin film in Example 2, the thickness after drying was changed to 24 μm, and in the production of prepreg therein, the glass cloth "IPC #2116" was changed to a glass cloth "IPC #1078" (available from Nitto Boseki Co., Ltd., basis weight: 47 g/m², substrate width: 530 mm, thickness: 44 μm). A copper-clad laminate 9 was produced by performing the same procedure as in Example 2 except that in the production of the copper-clad laminate in Example 2, the prepreg 9 was used instead of the prepreg 2. The evaluation results are shown in Table 1.

Example 10

A prepreg 10 (thickness: 140 μm) was produced by performing the same procedure as in Example 1 except that in the production of the prepreg in Example 1, the condition of the vacuum lamination was changed to a heating platen temperature of 90°C, a pressurizing pressure of 0.1 MPa, a vacuum degree of 100 kPa or less, and a vacuum time of 20 seconds. A copper-clad laminate 10 was produced by performing the same procedure as in Example 1 except that in the production of the copper-clad laminate in Example 1, the prepreg 10 was used instead of the prepreg 1. The evaluation results are shown in Table 1.

Example 11

A prepreg 11 (thickness: 65 μm) was produced by performing the same procedure as in Example 1 except that in the production of the resin film in Example 1, the thickness after drying was changed to 24 μm, and in the production of prepreg therein, the glass cloth "IPC #2116" was changed to a glass cloth "IPC #1078" (available from Nitto Boseki Co., Ltd., basis weight: 47 g/m$^2$, substrate width: 530 mm, thickness: 44 μm), and the condition of the vacuum lamination was changed to a heating platen temperature of 150°C, a pressurizing pressure of 0.8 MPa, a vacuum degree of 100 kPa or less, and a vacuum time of 120 seconds. A copper-clad laminate 11 was produced by performing the same procedure as in Example 1 except that in the production of the copper-clad laminate in Example 1, the prepreg 11 was used instead of the prepreg 1. The evaluation results are shown in Table 1.

Comparative Example 1

A glass cloth "IPC #2116" (available from Nitto Boseki Co., Ltd., basis weight: 104 g/m$^2$, substrate width: 530 mm, thickness: 91 μm) was impregnated with the resin varnish A prepared in Production Example 1, then taken out therefrom, and dried by heating to 140°C for 3.5 minutes to provide a prepreg X (thickness: 180 μm). A copper-clad laminate X was produced by performing the same procedure as in Example 1 except that in the production of the copper-clad laminate in Example 1, the prepreg X was used instead of the prepreg 1. The evaluation results are shown in Table 1.

It is understood that the prepreg X has a larger surface waviness than the prepregs 1 to 11 produced in Examples, and the copper-clad laminate X produced by using the prepreg X has a larger thickness variation. The existing ratio of the impregnated region of the prepreg X was unable to determine since the surface of the prepreg was not in focus in observing with the optical microscope due to the large surface waviness.

Example 12

A copper-clad laminate 12 was produced by performing the same procedure as in Example 2 except that in the production of the copper-clad laminate in Example 2, "2 plies of the prepregs 2" and "10 plies of the prepregs X produced in Comparative Example 1" were laminated instead of laminating 12 plies of the prepregs 2. The order of lamination of the prepreg was (1 ply of prepreg 2)/(10 plies of prepregs X)/(1 ply of prepreg 2). The evaluation results are shown in Table 1.

Example 13

A copper-clad laminate 13 was produced by performing the same procedure as in Example 2 except that in the production of the copper-clad laminate in Example 2, "4 plies of the prepregs 2" and "8 plies of the prepregs X produced in Comparative Example 1" were laminated instead of laminating 12 plies of the prepregs 2. The order of lamination of the prepreg was (2 plies of prepregs 2)/(8 plies of prepregs X)/(2 plies of prepregs 2). The evaluation results are shown in Table 1.

Table 1

| | | Example | | | | | | | | | | | | | | | | CE |
|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | | 13 | | 1 |
| Kind of copper-clad laminate | | 1 | 2 | 3 | 4 | 5 | 6 | 7 | 8 | 9 | 10 | 11 | 12 | | 13 | | X |
| Prepreg | Kind of prepreg | 1 | 2 | 3 | 4 | 5 | 6 | 7 | 8 | 9 | 10 | 11 | 2 | X | 2 | X | X |
| | Kind of resin varnish | A | A | B | A | A | A | A | B | A | A | A | A | A | A | A | A |
| | Kind of glass cloth | #2116 | #2116 | #2116 | #2116 | #2116 | #2116 | #3313 | #3313 | #1078 | #2116 | #1078 | #2116 | #2116 | #2116 | #2116 | #2116 |
| | Thickness of glass cloth ($\mu$m) | 91 | 91 | 91 | 91 | 91 | 91 | 73 | 73 | 44 | 91 | 44 | 91 | 91 | 91 | 91 | 91 |
| | Content ratio of thermosetting resin composition (% by mass) | 45 | 45 | 50 | 45 | 45 | 45 | 50 | 55 | 55 | 45 | 55 | 45 | 45 | 45 | 45 | 45 |
| | Thickness of prepreg ($\mu$m) | 130 | 125 | 125 | 115 | 110 | 125 | 105 | 105 | 70 | 140 | 65 | 125 | 180 | 125 | 180 | 180 |
| | Number of plies laminated in production of copper-clad laminate | 12 | 12 | 12 | 12 | 12 | 12 | 12 | 12 | 12 | 12 | 12 | 2 | 10 | 4 | 8 | 12 |

(continued)

|  |  | Example |  |  |  |  |  |  |  |  |  |  |  |  | CE |
|---|---|---|---|---|---|---|---|---|---|---|---|---|---|---|---|
|  |  | 1 | 2 | 3 | 4 | 5 | 6 | 7 | 8 | 9 | 10 | 11 | 12 | 13 | 1 |
| Evaluation results of prepreg | 1. Surface waviness Wa (μm) | 0.4 | 0.6 | 0.6 | 1.8 | 3.2 | 0.5 | 0.7 | 0.8 | 0.6 | 0.4 | 3.8 | 5.7 | 5.7 | 5.7 |
|  | 2. Surface roughness Ra (μm) | 0.4 | 0.4 | 0.4 | 0.4 | 0.5 | 1.3 | 0.4 | 0.4 | 0.4 | 0.4 | 0.4 | 0.6 | 0.6 | 0.6 |
|  | 3. Existing ratio of impregnated region (%) | 42 | 60 | 57 | 91 | 94 | 76 | 68 | 63 | 82 | 26 | 97 | - *1 | - *1 | - *1 |
|  | 4. Handleability | A | A | A | A | A | A | A | A | A | B | A | A | A | A |
|  | 5. Difference in thickness on both surfaces | 2 | 3 | 3 | 2 | 3 | 1 | 2 | 3 | 3 | 2 | 3 | 5 | 5 | 5 |
| Evaluation results of copper-clad laminate | 6. Thickness variation of copper-clad laminate (%) | 0.4 | 0.6 | 0.5 | 1.4 | 1.9 | 0.4 | 0.6 | 0.5 | 0.6 | 0.4 | 2.3 | 2.4 | 1.8 | 3.2 |
|  | 7. Solder heat resistance of copper clad laminate (min) | > 60 | > 60 | > 60 | > 60 | > 60 | > 60 | > 60 | > 60 | > 60 | > 60 | > 60 | > 60 | > 60 | > 60 |
|  | 8. Warpage amount of copper-clad laminate (mm) | A | A | A | A | A | A | A | A | A | A | A | - | - | A |

* 1: unmeasurable
CE: Comparative Example

It is understood from Table 1 that the use of the prepreg of the present embodiment provides high thickness accuracy of the copper-clad laminate irrespective of the use of a fiber substrate having a relatively large waviness, i.e., a fiber substrate having a thickness of 40 $\mu$m or more (see Examples 1 to 13). It can be said that the copper-clad laminates of Examples 1 to 13 are excellent in solder heat resistance of copper clad and sufficiently suppressed in generation of voids. Furthermore, it is understood that the difference in resin thickness overlaid on the fiber substrate on both surfaces of the prepreg is small, and as a result, the warpage amount of the copper-clad laminate is suppressed small.

On the other hand, as shown in Comparative Example 1, the prepreg produced by the method of impregnating a glass cloth with a resin varnish, followed by drying, has a large surface waviness (Wa) and a large thickness variation of the copper-clad laminate.

**Claims**

1. A prepreg comprising a fiber substrate having a thickness of 40 $\mu$m or more impregnated with a thermosetting resin composition, the prepreg having in the fiber substrate an impregnated region and a non-impregnated region with the thermosetting resin composition, having a surface waviness (Wa) of 5.0 $\mu$m or less.

2. The prepreg according to claim 1, wherein the prepreg has an existing ratio of the impregnated region obtained by the following calculation method of 25 to 98%:
   calculation method: a surface of the prepreg is observed with an optical microscope at a magnification of 50 to provide a surface observation image; the resulting surface observation image is converted to monochrome mode with image editing software, and saved in BMP (Microsoft Windows Bitmap Image) format; the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.

3. The prepreg according to claim 2, wherein the existing ratio of the impregnated region is 35 to 90%.

4. The prepreg according to any one of claims 1 to 3, wherein the prepreg has a surface roughness (Ra) of 0.1 to 5 $\mu$m.

5. The prepreg according to any one of claims 1 to 4, wherein the fiber substrate has a thickness of 70 to 120 $\mu$m.

6. A laminate comprising one or more plies of the prepreg according to any one of claims 1 to 5.

7. A metal-clad laminate comprising a metal foil and one or more plies of the prepreg according to any one of claims 1 to 5.

8. A printed wiring board comprising the laminate according to claim 6 or the metal-clad laminate according to claim 7.

9. A semiconductor package comprising the printed wiring board according to claim 8 and a semiconductor device.

10. A method of producing a prepreg having a surface waviness (Wa) of 5.0 $\mu$m or less, comprising impregnating a fiber substrate having a thickness of 40 $\mu$m or more with a film of a thermosetting resin composition through lamination, the method of producing a prepreg including providing in the fiber substrate an impregnated region and a non-impregnated region with the thermosetting resin composition.

11. The method of producing a prepreg according to claim 10, wherein the prepreg has an existing ratio of the impregnated region obtained by the following calculation method of 25 to 98%:
    calculation method: a surface of the prepreg is observed with an optical microscope at a magnification of 50 to provide a surface observation image; the resulting surface observation image is converted to monochrome mode with image editing software, and saved in BMP (Microsoft Windows Bitmap Image) format; the surface observation image in monochrome mode saved in BMP format is converted to RGB (red, green, blue) values pixel by pixel with image converting software, and then saved in CSV (comma-separated values) format; the RGB data saved in CSV format is pasted on Microsoft Excel (available from Microsoft Corporation), and calculated for areas of a black part (RGB value = 255) and a white part (RGB value = 0); an area ratio of the black part with respect to the total of the black part and the white part is calculated from the resulting values; and the area ratio of the black part obtained is designated as the existing ratio of the impregnated region.

12. A method of producing a metal-clad laminate, comprising disposing metal foils on both surfaces of one ply of a prepreg produced by the production method according to claim 10 or 11, or on both surfaces of a prepreg laminate including one or more plies of the prepreg, and then press-molding.

Fig. 1

Resin film

Non-impregnated region with
thermosetting resin composition

Fiber substrate

Fig. 2

Thermosetting resin composition

Fiber substrate

Fig. 3

Fiber substrate

Resin thickness overlaid on fiber
substrate T1 (front surface)

Thickness of fiber substrate

Resin thickness overlaid on fiber
substrate T2 (back surface)

Fig. 4

## INTERNATIONAL SEARCH REPORT

| International application No. |
| --- |
| **PCT/JP2022/021851** |

| **A. CLASSIFICATION OF SUBJECT MATTER** |
| --- |
| ***B29B 11/16***(2006.01)i; ***B32B 5/02***(2006.01)i; ***B32B 5/28***(2006.01)i; ***C08J 5/24***(2006.01)i; ***H05K 1/03***(2006.01)i; ***H05K 3/46***(2006.01)i <br> FI: B29B11/16; B32B5/02 Z; B32B5/28 Z; C08J5/24 CEZ; H05K1/03 610L; H05K3/46 S |
| According to International Patent Classification (IPC) or to both national classification and IPC |

| **B. FIELDS SEARCHED** |
| --- |
| Minimum documentation searched (classification system followed by classification symbols) <br> B29B11/16; B32B5/02; B32B5/28; C08J5/24; H05K1/03; H05K3/46 |
| Documentation searched other than minimum documentation to the extent that such documents are included in the fields searched <br> Published examined utility model applications of Japan 1922-1996 <br> Published unexamined utility model applications of Japan 1971-2022 <br> Registered utility model specifications of Japan 1996-2022 <br> Published registered utility model applications of Japan 1994-2022 |
| Electronic data base consulted during the international search (name of data base and, where practicable, search terms used) |

| **C. DOCUMENTS CONSIDERED TO BE RELEVANT** | | |
| --- | --- | --- |
| Category* | Citation of document, with indication, where appropriate, of the relevant passages | Relevant to claim No. |
| X | JP 2013-180406 A (SUMITOMO BAKELITE CO LTD) 12 September 2013 (2013-09-12) <br> claims, paragraphs [0021], [0034], [0038], [0045], [0046], [0133]-[0136], [0171], [0174]-[0180], [0196]-[0222], examples, fig. 3 | 1-12 |
| Y | | 1-12 |
| X | JP 2019-199062 A (MITSUBISHI HEAVY IND LTD) 21 November 2019 (2019-11-21) <br> claims, paragraphs [0043]-[0054], fig. 2 | 1-6, 10, 11 |
| X | JP 2007-099966 A (MITSUBISHI RAYON CO LTD) 19 April 2007 (2007-04-19) <br> claims, paragraphs [0013], [0024], [0025], [0027]-[0050], examples, fig. 1 | 1-6, 10, 11 |
| X | JP 2004-106347 A (MITSUBISHI RAYON CO LTD) 08 April 2004 (2004-04-08) <br> claims, paragraphs [0015], [0016], [0021]-[0027], examples, fig. 2 | 1-6, 10, 11 |
| Y | WO 2017/122820 A1 (HITACHI CHEMICAL COMPANY, LTD.) 20 July 2017 (2017-07-20) <br> claims, paragraphs [0014], [0018]-[0038], [0044]-[0056], examples | 1-12 |

| ✓ Further documents are listed in the continuation of Box C. | ✓ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **01 July 2022** | **19 July 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**

| International application No. |
| --- |
| **PCT/JP2022/021851** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2019-157009 A (HITACHI CHEMICAL COMPANY, LTD.) 19 September 2019 (2019-09-19)<br>claims, examples, entire text | 1-12 |
| A | JP 2011-132535 A (SUMITOMO BAKELITE CO LTD) 07 July 2011 (2011-07-07)<br>claims, examples, entire text | 1-7 |

Form PCT/ISA/210 (second sheet) (January 2015)

International application No.

**PCT/JP2022/021851**

| Patent document cited in search report | | | Publication date (day/month/year) | Patent family member(s) | | | Publication date (day/month/year) |
|---|---|---|---|---|---|---|---|
| JP | 2013-180406 | A | 12 September 2013 | (Family: none) | | | |
| JP | 2019-199062 | A | 21 November 2019 | US | 2021/0008818 | A1 | |
| | | | | EP | 3647012 | A1 | |
| | | | | claims, paragraphs [0043]-[0054], fig. 2 | | | |
| | | | | WO | 2019/220914 | A1 | |
| | | | | CN | 110997268 | A | |
| JP | 2007-099966 | A | 19 April 2007 | (Family: none) | | | |
| JP | 2004-106347 | A | 08 April 2004 | US | 2006/0035548 | A1 | |
| | | | | claims, paragraphs [0119]-[0225], examples, fig. 2 | | | |
| | | | | US | 2009/0123717 | A1 | |
| | | | | US | 2011/0151206 | A1 | |
| | | | | US | 2012/0276795 | A1 | |
| | | | | US | 2014/0057514 | A1 | |
| | | | | WO | 2004/009314 | A1 | |
| | | | | EP | 1541312 | A1 | |
| | | | | EP | 2298522 | A2 | |
| | | | | EP | 2311618 | A2 | |
| | | | | EP | 2314434 | A2 | |
| | | | | EP | 2578388 | A2 | |
| | | | | CN | 1668433 | A | |
| | | | | CN | 101181827 | A | |
| | | | | CN | 101181828 | A | |
| | | | | CN | 101181833 | A | |
| WO | 2017/122820 | A1 | 20 July 2017 | US | 2019/0037691 | A1 | |
| | | | | claims, paragraphs [0045], [0053]-[0038], [0112]-[0135], examples | | | |
| | | | | EP | 3403801 | A1 | |
| | | | | CN | 108472831 | A | |
| | | | | KR | 10-2018-0103061 | A | |
| | | | | TW | 201736459 | A | |
| JP | 2019-157009 | A | 19 September 2019 | (Family: none) | | | |
| JP | 2011-132535 | A | 07 July 2011 | US | 2009/0126974 | A1 | |
| | | | | claims, examples | | | |
| | | | | US | 2011/0120630 | A1 | |
| | | | | WO | 2007/040125 | A1 | |
| | | | | CN | 101223015 | A | |
| | | | | KR | 10-2009-0101968 | A | |
| | | | | CN | 101973146 | A | |
| | | | | KR | 10-2008-0009157 | A | |
| | | | | TW | 200724583 | A | |

Form PCT/ISA/210 (patent family annex) (January 2015)

## REFERENCES CITED IN THE DESCRIPTION

**Patent documents cited in the description**

- JP 1272416 A

- JP 2011132535 A